# EUROPEAN PATENT APPLICATION

(11) **EP 0 845 746 A2**
(43) Date of publication of application: **03.06.1998**
(21) Application number: 97309576.3
(22) Date of filing: 27.11.1997
(51) Int. Cl.: G06F 17/50

(54) **Printed circuit board cad apparatus which determines design parameter values**

(30) Priority: 27.11.1996 JP 316668/96
(71) Applicant: MATSUSHITA ELECTRIC INDUSTRIAL CO., LTD., Kadoma-shi, Osaka 571 (JP)
(72) Inventor: Fukumoto, Yukihiro, Kyotanabe-shi, Kyoto-fu 610-03 (JP); Miura, Shinji, Fushimi-ku, Kyoto-shi, Kyoto-fu 612 (JP); Ikeda, Hiroshi, Neyagawa-shi, Osaka-fu 572 (JP); Watanabe, Takahiro, Hirakata-shi, Osaka-fu 573 (JP); Saito, Yoshiyuki, Hirakata-shi, Osaka-fu 573 (JP); Uemura, Hirokazu, Yao-shi, Osaka-fu 581 (JP)
(74) Representative: Crawford, Andrew Birkby

(57) **Abstract**

A CAD apparatus is constructed to determine unknown design parameter values from known design parameter values using a plurality of rules concerning the design parameters and using a plurality of formulas including the design parameters. By using the known design parameter values determined through the use of the rules and the formulas, a printed circuit board is laid out. When a design parameter value which violates any of the rules and the formulas exists after the generation of the layout, the design parameter value in violation of any of the rules and the formulas is fixed and the design parameter values are redetermined through the use of the rules and formulas relating to the design parameter in violation.

## Description

### BACKGROUND OF THE INVENTION

### 1.Field of the Invention

The present invention relates to a CAD (Computer Aided Design) apparatus for designing a printed circuit board, the printed circuit board CAD apparatus especially for supporting a determination of unknown design parameter values.

### 2. Description of the Prior Art

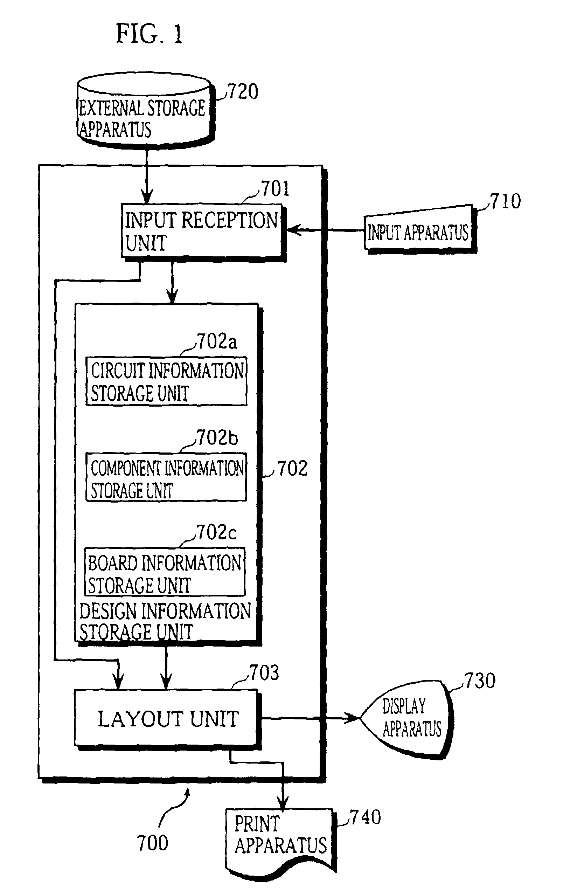

Printed circuit board CAD apparatuses have been widely used for designing printed circuit boards. Fig. 1 is a block diagram showing a widely-used printed circuit board CAD apparatus. As shown in the figure, conventional printed circuit board CAD apparatus 700 includes: input reception unit 701 for receiving user input from input apparatus 710 and external storage apparatus 720; design information storage unit 702 for storing design parameter values inputted from the input reception unit 701, such as circuit information, component information, and board information; and layout unit 703 for interactively or automatically laying out components and wires on a printed circuit board in accordance with the circuit information and other information stored in the design information storage unit 702 and instructions inputted from the input reception unit 701. Display apparatus 730 displays and print apparatus 740 prints out the layout result outputted from the layout unit 703.

The following is a brief explanation of the operation of the printed circuit board CAD apparatus 700 with the above construction. A user first inputs design parameter values composed of circuit information, component information, and board information which are necessary for designing a printed circuit board, via the input apparatus 710. The circuit information is information on wires between components, the component information is on types and sizes of components to be used, and the board information is on a size of the printed circuit board and a number of layers of the printed circuit board. Some of the design parameter values are determined in advance by the user to avoid malfunctions, while some of the design parameter values are automatically determined in accordance with product specifications.

The inputted information is stored in the design information storage unit 702 via the input reception unit 701. The layout unit 703 then automatically or interactively generates a virtual layout of components and wires on the printed circuit board in accordance with conditions set by the design parameter values stored in the design information storage unit 702.

As described above, conventional printed circuit board CAD apparatuses require the user to determine unknown design parameter values. With the increases in the speed of circuit elements and in the density of printed circuit boards in recent years, measures against malfunctions caused by electromagnetic noise and against the radiation of electromagnetic noise are now regarded as more important than before. Accordingly, the determination of design parameter values has become extremely important.

For wiring of high-speed clock signal lines which require matching of impedance, for example, expert designers determine design parameter values such as foil width and terminating resistance value based on their years of experience and results of analysis, and wire the lines in accordance with the determined design parameter values.

Also, some printed circuit board CAD apparatuses design printed circuit boards by adjusting design parameter values during generation of a layout, in consideration of electromagnetic characteristics. Causes of malfunctions due to electromagnetic noise include crosstalk, which is to say, changes of signal values of one signal line caused by electromagnetic induction and coupling of an adjacent signal line. In order to avoid malfunctions caused by the crosstalk, a wiring technique has been developed so that a crosstalk coefficient which is one of the design parameters is set below a reference value. This technique specifically relates to automatic wiring where factors which determine the value of the crosstalk coefficient, such as length of parallel lines and distance between the lines are controlled.

The conventional printed circuit board CAD apparatuses described above need expert designers who are capable of determining appropriate design parameter values which have to be calculated before operating the CAD apparatuses. This causes difficulties in designing appropriate printed circuit boards.

That is to say, a design parameter value is often determined by a plurality of factors, some of which cannot be found only from information such as design specifications. Thus, the designers have to appropriately determine such factors based on experience. If the designers are inexperienced, it may be very difficult to appropriately determine these factors.

Besides, since in a number of cases the factors which determine a design parameter value are other design parameter values, complicated interrelations between a plurality of design parameters make it extremely difficult to determine the design parameter values while making appropriate tradeoffs between them. Furthermore, though simulators and other apparatuses are used for supporting the determination of the design parameter values, the simulators have difficulties in understanding the complicated interrelations between the design parameters. As a result, skill and experience are still necessary for making adjustments between a plurality of design parameter values.

For example, a critical network such as a clock is wired manually in accordance with design conditions specified by professionals and expert designers. Thus, skill and experience are essential for designing circuit boards while optimizing design parameter values through the use of the printed circuit board CAD apparatuses.

Also, the above-mentioned printed circuit board CAD apparatuses which design printed circuit boards by adjusting the design parameter values have a problem in that they are incapable of adjusting design parameter values other than those which are adjustable during the generation of the layout. For example, a printed circuit board CAD apparatus for controlling the wiring to set the crosstalk coefficient below the reference value described above is designed to control only the design parameter values adjustable during the generation of the layout, such as the length of the parallel lines and the distance between the lines. Factors which determine the crosstalk coefficient, however, include not only factors which can be adjusted during the generation of the layout, such as the length of the parallel lines and the distance between the lines, but also factors which cannot be adjusted during the generation of the layout, such as distance between layers, foil width, and circuit board material. The fact that it is impossible to control these design parameter values means that there is little flexibility in designing the printed circuit board. While appropriate tradeoffs between design parameter values would be possible if the design parameter values which cannot be adjusted during the generation of the layout such as foil width were adjusted, adjustments of only the design parameter values which are adjustable during the generation of the layout may result in inappropriate tradeoffs between the design parameter values. Thus, the conventional printed circuit board CAD apparatuses described above lack flexibility in designing the printed circuit boards, due to their limited function of controlling only the design parameter values that are adjustable during the generation of the layout.

### SUMMARY OF THE INVENTION

It is an object of the present invention to provide a printed circuit board CAD apparatus in which it is unnecessary to predetermine design parameter values which are difficult to be determined in advance, so that even inexperienced designers can design a printed circuit board only by inputting known design parameter values into the printed circuit board CAD apparatus, and in which not only factors adjustable during generation of a layout but all factors for determining design parameter values can be controlled to determine the optimal design parameter values.

The above object can be fulfilled by determining unknown design parameter values from known design parameter values through the use of a plurality of rules concerning the design parameters and a plurality of formulas including the design parameters.

It should be noted here that the unknown design parameter values are all design parameter values other than the known design parameter values, which are to be determined through the use of the rules and the formulas.

That is to say, an unknown design parameter is set to a desired value using the rules and the formulas with the known design parameter values, the set design parameter value then being used to determine other unknown design parameter values using other rules and formulas. Thus, by using the known design parameter values, design parameter values which are difficult to be predetermined can be determined appropriately. By means of the above procedure, the designers do not have to go to the trouble of predetermining all design parameter values in consideration of electromagnetic and other characteristics, and even inexperienced designers can design a circuit easily.

Also, as the design parameter values are adjusted not during the generation of the layout but when the unknown design parameter values are determined, a determination of optimal design parameter values is possible by controlling all factors that determine the design parameter values, so that design flexibility can be improved.

Furthermore, the unknown design parameter values to be determined through the use of the rules and the formulas can be set as design parameter values relating to at least one of a wire and a board. Since there is a good possibility that the designers have to set such unknown design parameters to be determined at arbitrary values, printed circuit board design can be highly efficient by using the printed circuit board CAD apparatus of the present invention.

When a design parameter value which violates any of the rules and the formulas exists after laying out of the printed circuit board using the known design parameter values which have been determined through the use of the rules and the formulas, the design parameter values can be redetermined through the use of the rules and the formulas by fixing the design parameter value in violation.

By means of the above procedure, the design parameter value which violates any of the rules and the formulas can be made into an appropriate design parameter value which satisfies the rules and the formulas by adjusting design parameter values other than the design parameter value which violates any of the rules and the formulas. Then, by regenerating the layout through the use of the newly acquired design parameter values, a layout of the printed circuit board which does not violate the rules and formulas for the determined design parameter values can be created. By doing so, effective tradeoffs are made between the design parameter values, and a more appropriate printed circuit board can be designed. Also, since it is possible to fix the design parameter value which violates any of the rules and the formulas after the generation of the layout and to change other design parameter values without restriction, the printed circuit board can be designed with greater flexibility in the present invention than in the conventional method.

Also, an execution order of the rules and the formulas can be determined based on a specified standard. By doing so, the execution order can be determined so that design parameters included in at least two out of a plurality of rules and a plurality of formulas can be appropriately traded off in order to avoid producing design parameter values that violate the rules and the formulas, and the printed circuit board can be designed using more appropriately determined design parameter values.

When the above-mentioned specified standard for determining the execution order of the rules and the formulas is a standard rule based on known design parameter values, among design parameter values whose degrees of importance change in accordance with the known design parameter values, those with greater importance can be given priority in the determination order.

On the other hand, if the specified standard is defined so that rules and formulas which determine small numbers of unknown design parameter values are given priority in the execution order, unknown design parameter values are determined little by little. As a result, a lot of unknown design parameter values will have already been determined by the time rules and formulas of the later order are executed, and the probability of determining design parameter values which satisfy all of the rules and formulas will increase.

### BRIEF DESCRIPTION OF THE DRAWINGS

These and other objects, advantages and features of the invention will become apparent from the following description thereof taken in conjunction with the accompanying drawings that illustrate a specific embodiment of the invention. In the drawings:
Fig. 1 is a function block diagram of a conventional printed circuit board CAD apparatus;
Fig. 2 shows the hardware construction of a printed circuit board CAD apparatus of the present embodiment of the present invention;
Fig. 3 is a function block diagram of the printed circuit board CAD apparatus of the present embodiment of the present invention;
Fig. 4A shows an example of the rules concerning design parameters used by the first parameter determination units;
Fig. 4B shows another example of the rules concerning design parameters used by the first parameter determination units;
Fig. 5A is a perspective view showing an example of a printed circuit board;
Fig. 5B is a partially enlarged perspective view showing the part "A" of Fig. 5A;
Fig. 6A shows an example of the formulas including design parameters used by the second parameter determination units;
Fig. 6B shows another example of the formulas including design parameters used by the second parameter determination units;
Fig. 6C shows another example of the formulas including design parameters used by the second parameter determination units;
Fig. 7 shows an example of a standard used by the parameter determination order decision unit for deciding an execution order;
Fig. 8 is a flowchart showing the operation of the printed circuit board CAD apparatus of the present embodiment;
Fig. 9A is an overhead view showing an example of a circuit of a printed circuit board;
Fig. 9B shows a procedure of determining design parameter values and a layout of signal line X in Fig. 9A;
Fig. 9C is an overhead view showing a circuit of a printed circuit board which is a result of applying the execution of the procedure shown in Fig. 9B to the signal line X in Fig. 9A.

### DESCRIPTION OF THE PREFERRED EMBODIMENT

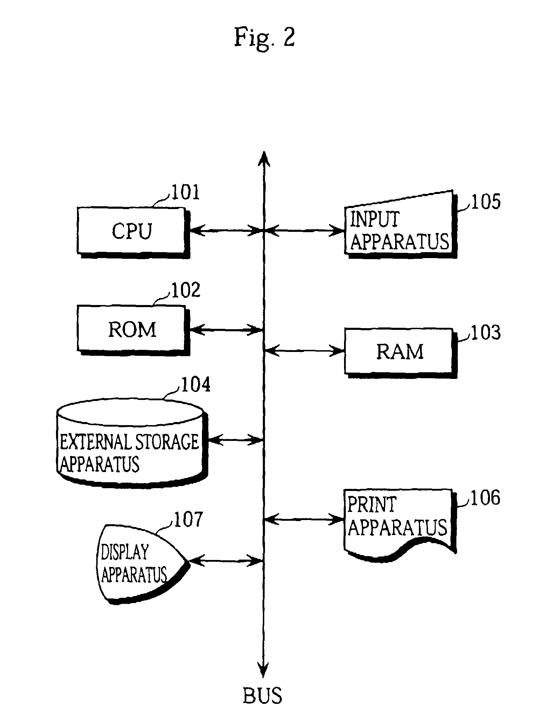

The following is an explanation of a printed circuit board CAD apparatus of an embodiment of the present invention with reference to the figures. Fig. 2 is a diagram showing the hardware construction of the printed circuit board CAD apparatus of the present embodiment. As shown in the figure, this printed circuit board CAD apparatus includes: CPU 101 for conducting arithmetic processing; ROM 102 for storing a program and other information; RAM 103 as a work area for the CPU 101; external storage apparatus 104 such as a hard disc for storing various sets of design data and other data; input apparatus 105 such as a mouse and a keyboard for receiving user input; print apparatus 106 such as a printer; and display apparatus 107 such as a CRT. The present printed circuit board CAD apparatus achieves the functions explained below using the program stored in the ROM 102. It should be noted here that this printed circuit board CAD apparatus can also be realized by installing an executable program which has the functions and the operations explained below into a general-purpose computer. Such a program can be recorded on a computer-readable recording medium such as a floppy disk.

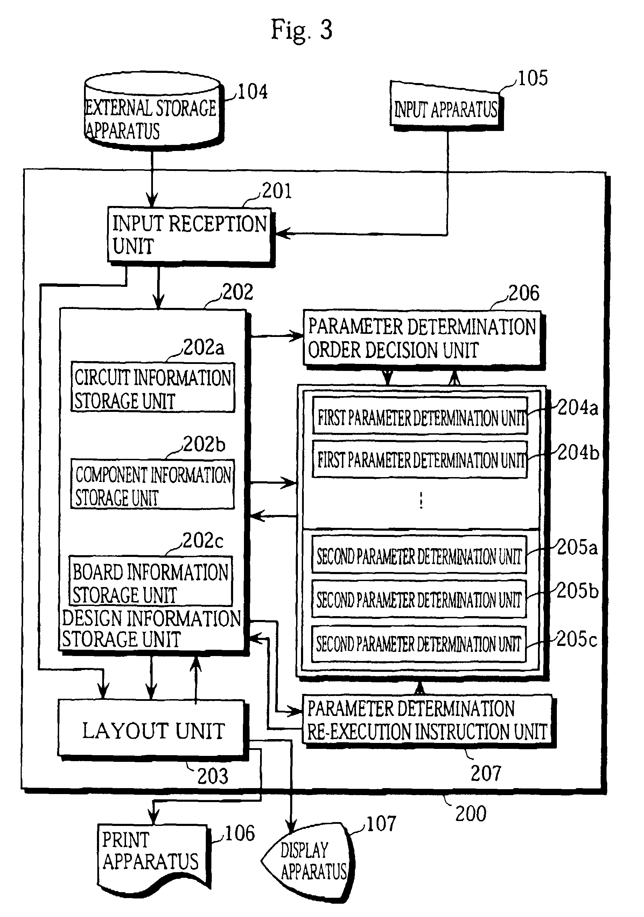

Fig. 3 is a function block diagram showing the present printed circuit board CAD apparatus 200. As shown in the figure, the printed circuit board CAD apparatus 200 functionally comprises: input reception unit 201; design information storage unit 202; layout unit 203; first parameter determination units 204a, 204b, ... ; second parameter determination units 205a, 205b, 205c, ... ; parameter determination order decision unit 206; and parameter determination re-execution instruction unit 207. The input reception unit 201 is connected to the input apparatus 105 and the external storage apparatus 104, while the layout unit 203 is connected to the display apparatus 107 and the print apparatus 106.

The input reception unit 201 receives user input of known design parameter values among design parameters including circuit information, component information, and board information via the external storage apparatus 104 and the input apparatus 105. The input reception unit 201 also receives instructions from the user.

The design information storage unit 202 comprises circuit information storage unit 202a for storing circuit information, component information storage unit 202b for storing component information, and board information storage unit 202c for storing board information. The design information storage unit 202 stores the known design parameter values received by the input reception unit 201 and design parameter values determined by the first and second parameter determination units 204a, 204b, ... , 205a, 205b, 205c ....

The first parameter determination units 204a, 204b, ... determine unknown design parameter values from known design parameter values using rules concerning the design parameters. Here, the known design parameter values include the design parameter values received by the input reception unit 201 and the design parameter values already determined by the first and second parameter determination units 204a, 204b, ..., 205a, 205b, 205c, .... These known design parameter values are stored in the design information storage unit 202.

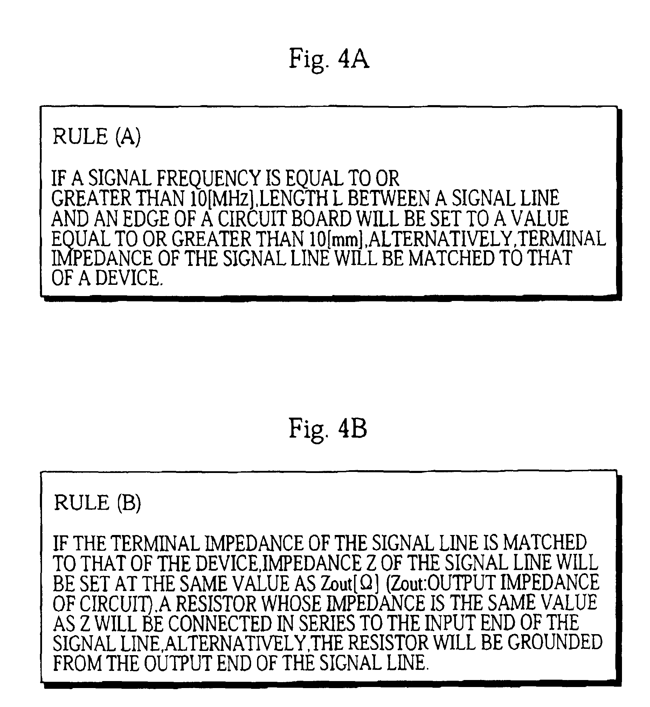

Examples of the rules concerning the design parameters are shown in Fig. 4A and Fig. 4B. Fig. 4A and Fig. 4B respectively show rule (A) and rule (B) of the first parameter determination units 204a and 204b. As shown in Fig. 4A and Fig. 4B, each "rule" is composed of a "condition" and a "result," so that design parameter values are determined in accordance with conditions. The "rule" defines functional conditions to be satisfied by the design parameters, and includes rules which are determined based on product specifications such as size of a circuit board, as well as rules which are determined based on physical conditions such as electromagnetic characteristics.

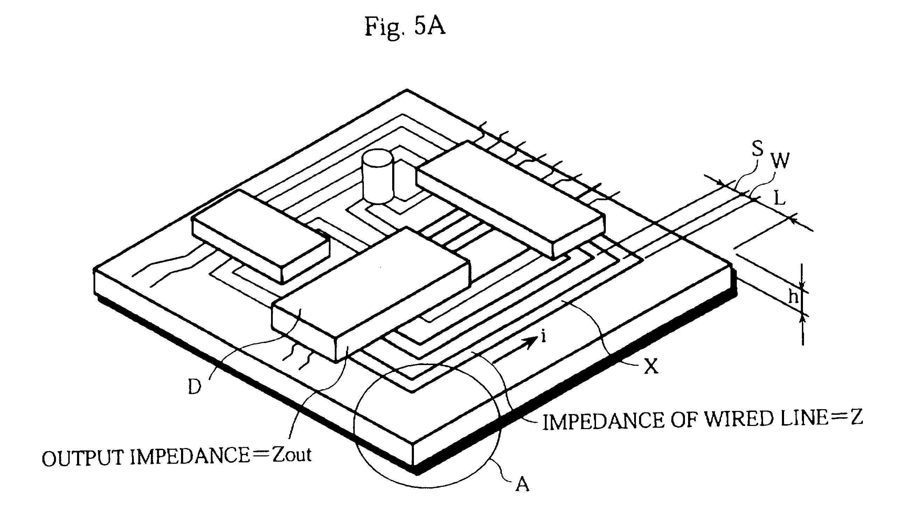

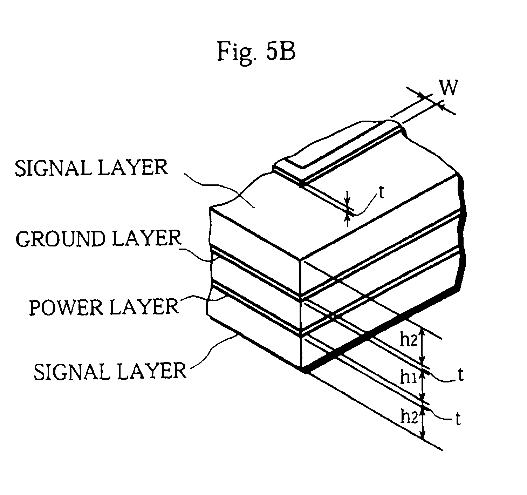

An example of determining design parameter values using rule (A) and rule (B) is explained with reference to Fig. 5A and Fig. 5B. Fig. 5A shows an example of a printed circuit board, and Fig. 5B is an enlargement of part "A" of Fig. 5A. For example, rule (A) of the first parameter determination unit 204a specifies that if a signal frequency is equal to or greater than 10[MHz], either length L between a signal line and an edge of a circuit board will be set to a value equal to or greater than 10[mm], or terminal impedance of the signal line will be matched to that of a device to which the signal line is connected. Accordingly, in the case of the signal line X in Fig. 5A, if the signal frequency is 20[MHz], which is greater than 10[MHz], either the length L between the signal line X and the edge of the circuit board is set to, for instance, 15[mm] which is greater than 10[mm] or the terminal impedance of the signal line is matched to that of the device D. On the other hand, if the signal frequency is below 10[MHz], the length L between the signal line X and the edge of the circuit board is not set at a particular value nor is the terminal impedance of the signal line matched to that of the device D.

Rule (A) is explained as follows. When the signal line is a high-speed signal line with a fundamental frequency greater than 10[MHz], it is preferable that a micro strip is used for wiring transmission lines symmetrical with respect to the wiring direction in order to suppress unbalanced currents which cause radiant noise and in order to reduce electromagnetic radiant noise. So rule (A) specifies that such a signal line should be wired at least 10[mm] inside the edge of the circuit board in order to control the distance between the line and the edge of the circuit board.

It is also possible to transmit signals with few errors and reduce the radiant noise by matching the terminal impedance of the signal line to that of the device to prevent ringing or crosstalk of the signals. Accordingly, rule (A) also specifies the matching of the terminal impedance of the signal line to that of the device as another option when the fundamental signal frequency exceeds 10[MHz].

Rule (B) of the first parameter determination unit 204b specifies that, if the terminal impedance of the signal line is to be matched to that of the device, either the impedance Z of the signal line will be set at the output impedance "Z out"[Ω] or a resistor whose impedance is the same as the impedance Z of the signal line will be connected in series to the input end of the signal line or will be grounded from the output end of the signal line. Thus, rule (B) specifies these options as methods for matching the terminal impedance of the signal line to that of the device.

For example, in the case of the signal line X in Fig. 5A, if the signal direction is "i" and the output impedance of the device D is "Z out", and if the terminal impedance of the signal line X is to be matched to that of the device, the impedance Z of the signal line X is set at "Z out".

It should be noted here that rule (A) of the first parameter determination unit 204a and rule (B) of the first parameter determination unit 204b are specified for a signal line. By applying these rules to each signal line on a printed circuit board, design parameter values such as impedance of each signal line are determined.

The known design parameter values already stored in the design information storage unit 202 are not redetermined. For these known parameter values, the first parameter determination units 204a, 204b, ... only judge whether these design parameter values satisfy the rules of the first parameter determination units 204a, 204b .... When any of these design parameter values violates the rules, the first parameter determination units 204a, 204b, ... output an error message which is then displayed on the display apparatus 107. This is also the case for the second parameter determination units 205a, 205b, 205c, ... explained below.

The second parameter determination units 205a, 205b, 205c, ... judge whether design parameter values satisfy formulas including the design parameters. The second parameter determination units 205a, 205b, 205c, ... use the formulas and the known design parameter values in order to determine unknown design parameter values. The known design parameter values used here have been stored in the design information storage unit 202 as described above.

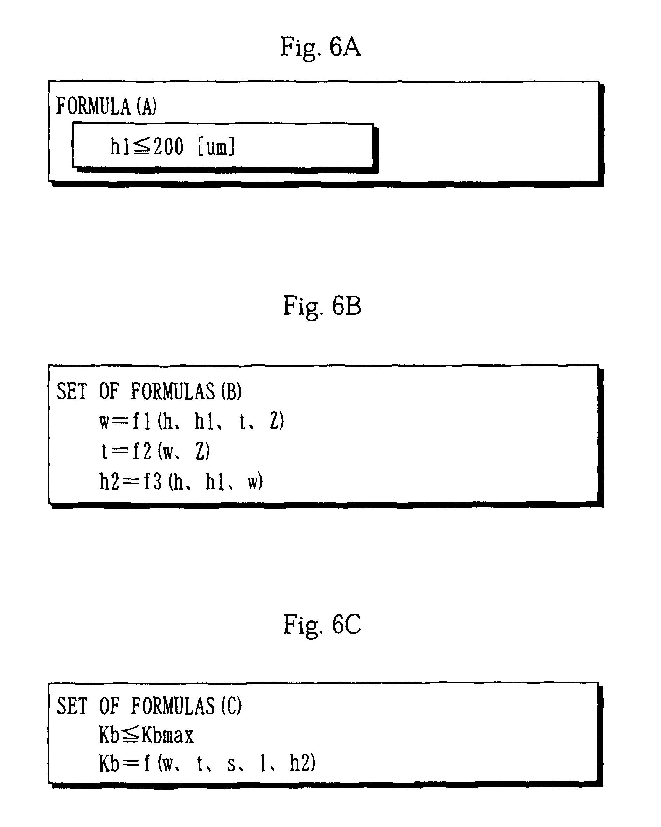

Figs. 6A, 6B, and 6C show specific examples of the formulas which include design parameters and which are based on design information. Figs. 6A, 6B, and 6C respectively show formula (A), set of formulas (B), and set of formulas (C) of the second parameter determination units 205a, 205b, and 205c. These formulas are relational formulas which should be satisfied by the design parameter values, and include not only formulas concerning interrelations between a plurality of design parameters but also formulas concerning only one design parameter. While in principle known formulas are used by the second parameter determination units, new formulas can also be specified and used.

Formula (A) of the second parameter determination unit 205a sets distance h1 between the power layer and the ground layer shown in Fig. 5B to 200[µm] or smaller in order to shorten the distance h1 and reduce the impedance of the power supply. By using this formula, for example, the distance h1 between the power layer and the ground layer shown in Fig. 5B is set to 100[µm].

Set of formulas (B) of the second parameter determination unit 205b relates to interrelations among impedance Z of a wired line, foil width w, foil thickness t, board thickness h, distance h1 between power layer and ground layer, and distance h2 between power layer and signal layer shown in Fig. 5A and Fig. 5B. For example, with this set of formulas, the second parameter determination unit 205b uses known design parameter values stored in the design information storage unit 202, such as the impedance Z and the distance hl between the power layer and the ground layer if these have been already stored in the design information storage unit 202, to determine unknown design parameter values such as the foil width w, the foil thickness t, the board thickness h, and the distance h2 between the power layer and the signal layer.

Set of formulas (C) of the second parameter determination unit 205c is composed of a formula which sets crosstalk coefficient Kb to a value equal to or smaller than inputted value "Kb max" in order to prevent crosstalk and a formula which shows interrelations among the crosstalk coefficient Kb, the foil width w, the foil thickness t, distance s between parallel lines, length 1 of the parallel lines, and the distance h2 between the power layer and the signal layer. By using these formulas, the second parameter determination unit 205c sets values of the foil width w, the foil thickness t, the distance s between the parallel lines, the length 1 of the parallel lines, and the distance h2 between the power layer and the signal layer so that the crosstalk coefficient Kb can be equal to or smaller than "Kb max", at the same time setting a value of the crosstalk coefficient Kb. Set of formulas (B) of the second parameter determination unit 205b and set of formulas (C) of the second parameter determination unit 205c are also specified for each signal line, like the above-described rules of the first parameter determination units.

As described above, these formulas are used to calculate unknown design parameter values through the use of known design parameter values stored in the design information storage unit 202. It should be noted here that there is a possibility that an unknown design parameter cannot be set to a particular value due to lack of a number of known design parameter values necessary for determining the unknown design parameter value. When this happens, a process is performed where several unknown design parameters are given arbitrary values so that all unknown design parameters in the formulas are determined so as to satisfy the formulas.

All necessary design parameters are specified by the first parameter determination units 204a, 204b, ... and the second parameter determination units 205a, 205b, 205c .... In addition to the design parameters mentioned above, the design parameters also include various parameters such as height of dielectric [µm], height of a component [mm], power consumption [mW], rise time [nsec], fall time [nsec], and input capacitance [pF], which can be defined in accordance with various circumstances.

The parameter determination order decision unit 206 decides an execution order of the first parameter determination units 204a, 204b, ... and the second parameter determination units 205a, 205b, 205c, ... based on a specified standard. Since some of the design parameters are included in at least two out of a plurality of the rules of the first parameter determination units 204a, 204b, ... and a plurality of the formulas of the second parameter determination units 205a, 205b, 205c, ... as shown in Figs. 4A, 4B, 6A, 6B, and 6C, "conflict" occurs during a determination of the design parameter values. As the control unit for minimizing effects caused by this "conflict", the parameter determination order decision unit 206 decides the execution order of the first parameter determination units 204a, 204b, ... and the second parameter determination units 205a, 205b, 205c, ....

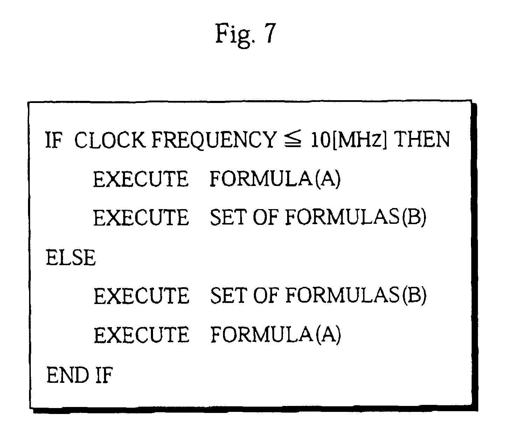

For instance, the parameter determination order decision unit 206 sets an instruction shown in Fig. 7 so that, if the clock frequency is equal to or lower than 10[MHz], formula (A) is the first to be executed by the second parameter determination unit 205a to set a value of the distance hl between the power layer and the ground layer before set of formulas (B) is executed by the second parameter determination unit 205b to set values of the impedance Z and other design parameters. The parameter determination order decision unit 206 also decides that if the clock frequency is greater than 10[MHz], the above execution order is to be performed in reverse, that is, set of formulas (B) is the first to be executed by the second parameter determination unit 205b to simultaneously set values of the impedance Z and the distance hl between the power layer and the ground layer, before executing formula (A) by the second parameter determination unit 205a. Here, since the distance hl between the power layer and the ground layer has already been determined as described above, the second parameter determination unit 205a only judges whether the determined value of the distance hl between the power layer and the ground layer satisfies formula (A). When the determined value of the distance hl between the power layer and the ground layer does not satisfy formula (A), the second parameter determination unit 205a outputs an error message which is then displayed on the display apparatus 107.

The reason for changing the execution order in the above case is that the shorter the distance hl between the power layer and the ground layer, the more stable the power supply will be, while the value of the impedance should be given priority if the clock frequency is greater than 10[MHz]. In other words, in the case of a slow signal with clock frequency of 10[MHz] or below, the distance hl between the power layer and the ground layer is given priority in the determination order in order to stabilize the power supply, while in the case of a high-speed signal with clock frequency exceeding 10[MHz], the impedance Z is given priority in the determination order in order to determine the value of the impedance Z first. By deciding the execution order, even if an error occurs during execution of parameter determination units which come later in the execution order of the first and second parameter determination units 204a, 204b, ... , 205a, 205b, 205c ... conditions which should be given priority will still be satisfied.

Other methods can be also used to decide the execution order of the first and second parameter determination units 204a, 204b, ..., 205a, 205b, 205c .... For instance, the execution order may be determined so that among the rules and the formulas of the first and second parameter determination units 204a, 204b, ... 205a, 205b, 205c, ... , a parameter determination unit which determines a small number of design parameter values is given priority in the execution order. By doing so, the number of design parameter values which satisfy the rules and the formulas of the first and second parameter determination units 204a, 204b, ..., 205a, 205b, 205c, ... can be increased.

Also, the parameter determination order decision unit 206 need not decide the execution order of all of the first and second parameter determination units at a same time, and may instead decide a next parameter determination unit in the execution order after each execution by one of the first and the second parameter determination units.

After the execution of all of the first parameter determination units 204a, 204b, ... and all of the second parameter determination units 205a, 205b, 205c, ... , the layout unit 203 automatically or interactively lays out components and wires on a printed circuit board in accordance with the design parameter values stored in the design information storage unit 202. Here, if any of the design parameter values amended during the generation of the layout violates any of the rules and formulas, the layout processing is continued, ignoring the violation.

When a design parameter value which violates any of the rules and the formula for the design parameter value determined by the first parameter determination units 204a, 204b, ... and the second parameter determination units 205a, 205b, 205c, ... exists after the layout unit 203 lays out the printed circuit board, the parameter determination re-execution instruction unit 207 fixes the design parameter value in violation and instructs first and second parameter determination units relating to the design parameter in violation to re-execute the determination of the design parameter values.

More specifically, the parameter determination re-execution instruction unit 207 instructs the first parameter determination units 204a, 204b, ... and the second parameter determination units 205a, 205b, 205c, ... to execute and to extract design parameter values in violation of any of the rules and the formulas out of all of the design parameter values acquired after the generation of the layout. When a design parameter value in violation of any of the rules and the formulas exists, the parameter determination re-execution instruction unit 207 fixes the design parameter value in violation, resets design parameter values other than the design parameter value in violation, and instructs the first and second parameter determination units which have any of the rules and the formulas relating to the design parameter in violation to re-execute the determination of the design parameter values. When changes of the design parameter values as a result of re-executing the determination of the design parameter values affect other design parameter values, the parameter determination re-execution instruction unit 207 further instructs first and second parameter determination units relating to the affected design parameter values to re-execute the determination of the design parameter values.

An example is given in the case of a bus network, in which length 1 of parallel lines, despite having been set at a particular value so that crosstalk coefficient Kb would not exceed a reference value in formula (C) of the second parameter determination unit 204c in Fig. 6C, exceeds a specified value after a generation of a layout. The parameter determination re-execution instruction unit 207 fixes the length 1 of the parallel lines after the generation of the layout and instructs parameter determination units which relate to the crosstalk coefficient Kb or the length 1 of the parallel lines among the first and second parameter determination units 204a, 204b, ... , 205a, 205b, 205c, ... to re-execute the determination of the design parameter values. By doing this, the length 1 of the parallel lines in violation of formula (C) remains at the same value, while changes are made for the other design parameter values such as board thickness, so that the layout can be regenerated so that the crosstalk coefficient Kb does not exceed the reference value. Thus, as a result of making tradeoffs between the design parameter values so that the design parameter value initially in violation of any of the rules and-the formulas ends up satisfying the rules and the formulas, all of the design parameters can be set at appropriate values.

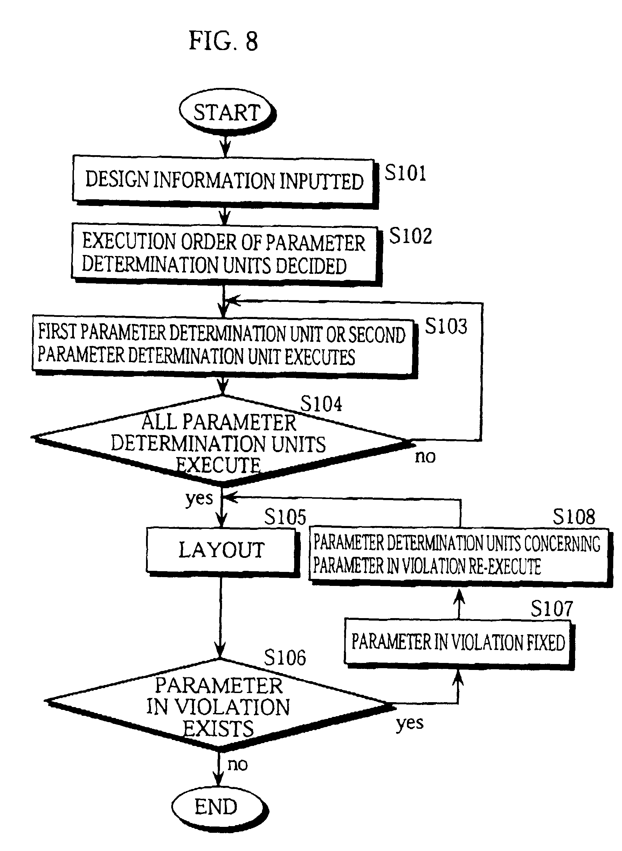

The following is an explanation of the operation of the printed circuit board CAD apparatus with the above construction. Fig. 8 is a flowchart showing the operation of the printed circuit board CAD apparatus. First, a user inputs known design parameter values including circuit information, component information, and board information which have been predetermined based on information such as design specifications via the input apparatus 105 or the external storage apparatus 104 (S101). These inputted known design parameter values are received by the input reception unit 201 of the printed circuit board CAD apparatus, and stored in the design information storage unit 202.

Next, the parameter determination order decision unit 206 decides an execution order of the first parameter determination units 204a, 204b, ... and the second parameter determination units 205a, 205b, 205c, ... based on the known design parameter values stored in the design information storage unit 202 (S102).

The first parameter determination units 204a, 204b, ... and the second parameter determination units 205a, 205b, 205c, ... determine unknown design parameter values in accordance with the execution order decided by the parameter determination order decision unit 206 (S103). These design parameter values determined by the first parameter determination units 204a, 204b, ... and the second parameter determination units 205a, 205b, 205c, ... are then stored in the design information storage unit 202. Here, through a process of using design parameters set at desirable values based on the rules for determining other design parameter values through the use of the formulas including a plurality of design parameters, each appropriate design parameter value is stored one after another in the design information storage unit 202. An example of such a process is that, after setting impedance Z of a wired line at an appropriate value through the use of rule (B) of the first parameter determination unit 204b, other design parameter values are determined by set of formulas (B) of the second parameter determination unit 205b using the set value of the impedance z.

After completing the execution of all of the first and second parameter determination units 204a, 204b, ... , 205a, 205b, 205c, ... (S104), the layout unit 203 automatically or interactively lays out a printed circuit board based on the design parameter values stored in the design information storage unit 202 (S105).

After the layout unit 203 lays out the printed circuit board, each of the design parameter values is judged to see whether it violates any rule or formula for the design parameter value stored in the design information storage unit 202 (S106). When no design parameter values acquired after the generation of the layout violate the rules and formulas, the operation of the printed circuit board CAD apparatus is completed. On the other hand, when any of the design parameter values acquired after the generation of the layout violates any of the rules and formulas, the parameter determination re-execution instruction unit 207 fixes the design parameter value in violation (S107), and instructs parameter determination units relating to the design parameter in violation among the first and second parameter determination units 204a, 204b, ... , 205a, 205b, 205c, ... to re-execute the determination of the design parameter values (S108). Then, the layout unit 203 regenerates the layout of the printed circuit board using the newly determined design parameter values. This process is repeated until all of the design parameter values acquired after the generation of the layout do not violate the rules and formulas for the resign parameter values stored in the design information storage unit 202. When the layout is generated with no design parameter values in violation of the rules and the formulas, the operation of the printed circuit board design is completed.

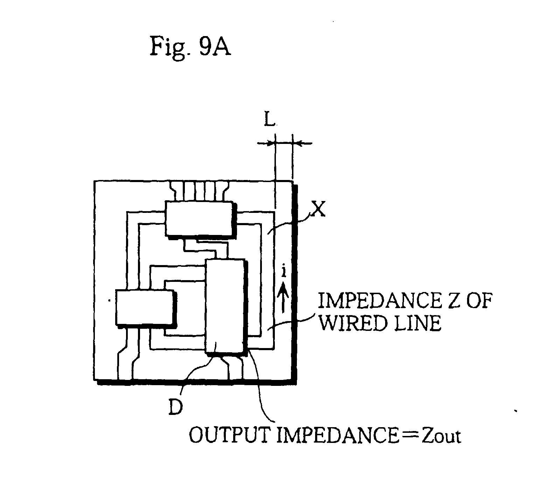

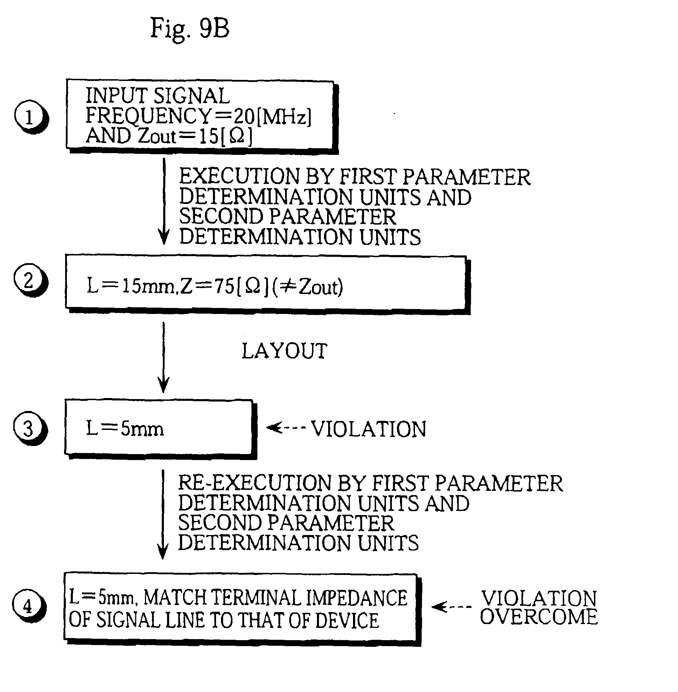

The following is a more specific explanation of the above operation using a simple example. Here, a process of determining design parameter values and a layout of signal line X in designing a printed circuit board shown in Fig. 9A is explained. The determination process is shown in Fig. 9B. As shown in Fig. 9A, the signal line X is set such that impedance of the wired line is "Z", signal direction is "i", and the output impedance of the device D from which the signal is outputted is "Z out".

It is supposed here that information that the signal frequency is 20[MHz] and that the output impedance "Z out" is 15 [Ω] is inputted from a user as known design parameter values (Fig. 9B ①). Next, the first parameter determination units 204a, 204b, ... and the second parameter determination units 205a, 205b, 205c, ... execute a determination of unknown design parameter values.

More specifically, as the signal frequency is 20[MHz], the length L between the signal line X and the edge of the circuit board is set at 15[mm] which is longer than 10[mm] based on rule (A) in Fig. 4A, while the terminal impedance of the signal line is not matched to that of the device D. Rule (B) in Fig. 4B is thus not enforced, as the rule (B) does not apply to this case. On the other hand, as a result of the execution of other parameter determination units, the impedance z of the signal line X is set to 75[Ω] (Fig. 9B ②).

Next, the printed circuit board is laid out using the known design parameter values. It is supposed here that the length L between the signal line X and the edge of the circuit board becomes 5[mm] as a result of the generation of the layout. This value of the length L between the signal line X and the edge of the circuit board violates rule (A) in Fig. 4A. Accordingly, the parameter determination re-execution instruction unit 207 fixes the value of the length L between the signal line X and the edge of the circuit board at 5[mm], and instructs the first parameter determination units 204a, 204b, ... and the second parameter determination units 205a, 205b, 205c, ... to re-execute the determination of the design parameter values.

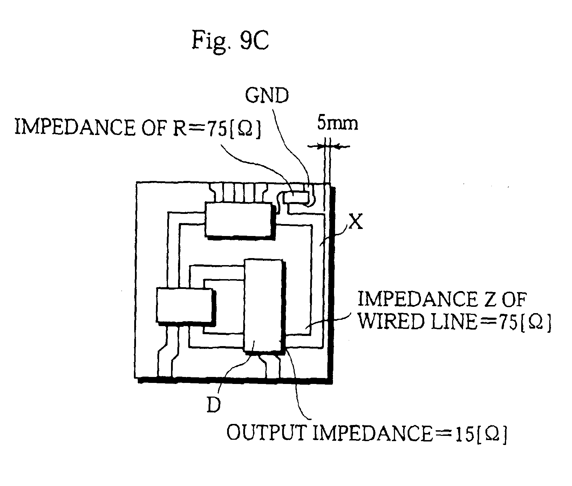

Here, rule (A) in Fig. 4A is enforced again, and this time it is determined that the terminal impedance of the signal line X will be matched to that of the device D, since the length L between the signal line and the edge of the circuit board has been fixed at 5[mm]. Accordingly, rule (B) in Fig. 4B applies to this case, so that the procedure of matching the terminal impedance of the signal line X to that of the device D is chosen. Since the value of "Z out" is not equal to Z in this example, it is decided to ground a resistor R with impedance of 75[Ω] from the output end of the signal line X (Fig. 9B ④). By the above procedure, the violation concerning the signal line X is overcome, and the design parameter values and the layout of the signal line X are determined as shown in Fig. 9C.

It should be noted that while the rules of the first parameter determination units and the formulas of the second parameter determination units are predetermined in the present embodiment, it is also possible for a user to add and/or delete rules and formulas for each circuit board design via the input reception unit.

When design parameter values in violation of rules or formulas exist, it is also possible for the user to edit design parameters, such as by changing of the design parameter values in violation of the rules or the formulas and the related design parameter values before the re-execution of the design parameter determination, while in the present embodiment all design parameter values in violation are fixed, and the first and second parameter determination units which have the rules and the formulas concerning the design parameters in violation re-execute the determination of the design parameter values.

Although the present invention has been fully described by way of examples with reference to the accompanying drawings, it is to be noted that various changes and modifications will be apparent to those skilled in the art. Therefore, unless such changes and modifications depart from the scope of the present invention, they should be construed as being included therein.

## Claims

1. A printed circuit board CAD apparatus for supporting a determination of respective values of a plurality of specified design parameters, comprising:
input reception means for receiving at least one design parameter value, out of the respective values of the plurality of specified design parameters, which is determined in advance;
parameter value storage means for storing determined design parameter values;
at least one first parameter determination means having a rule, the rule including a condition including at least one design parameter and a result relating to at least one value of at least one design parameter other than the design parameters included in the condition, for determining, when at least one design parameter value out of the values of the design parameters relating to the result is unknown, the unknown design parameter values using the rule and at least one design parameter value out of the determined design parameter values stored in said parameter value storage means; and
at least one second parameter determination means having at least one formula including a plurality of design parameters, for determining, when at least one value of at least one design parameter out of the plurality of design parameters included in the formula is unknown, the unknown design parameter values using the formula and at least one design parameter value out of the determined design parameter values stored in said parameter value storage means,
wherein each design parameter, out of the design parameters whose values relate to the results of the rules of said first parameter determination means and the design parameters included in the formulas of said second parameter determination means, is one of the plurality of specified design parameters, and
wherein the determined design parameter values stored in said parameter value storage means include the design parameter values received by said input reception means, the design parameter values determined by said first parameter determination means, and the design parameter values determined by said second parameter determination means.

2. The printed circuit board CAD apparatus of Claim 1, wherein the design parameter values determined by said first parameter determination means and the design parameter values determined by said second parameter determination means are design parameter values concerning at least one of a wire and a board.

3. The printed circuit board CAD apparatus of Claim 1, further comprising:
layout means for laying out a printed circuit board using a plurality of known design parameter values, the plurality of known design parameter values including the design parameter values received by said input reception means, the design parameter values determined by said first parameter determination means, and the design parameter values determined by said second parameter determination means; and
parameter determination re-execution instruction means for fixing, when a design parameter value which violates any of the rules and the formulas exists after said layout means lays out the printed circuit board, the design parameter value and instructing each first parameter determination means whose rule is violated by the design parameter value and each second parameter determination means whose formula is violated by the design parameter value to re-execute a determination of the design parameter values,
wherein in the re-execution of the first parameter determination means and the second parameter determination means at least one design parameter value other than the fixed design parameter value is treated as an unknown design parameter value.

4. The printed circuit board CAD apparatus of Claim 3, further comprising:
parameter determination order decision means for deciding, based on any of a plurality of predetermined standards, an execution order of said first parameter determination means and said second parameter determination means.

5. The printed circuit board CAD apparatus of Claim 4,
wherein the plurality of predetermined standards include a standard rule based on at least one of the plurality of known design parameter values.

6. The printed circuit board CAD apparatus of Claim 4,
wherein the plurality of predetermined standards include a standard that gives priority in the execution order to a parameter determination means, out of said first parameter determination means and said second parameter determination means, which determines a small number of unknown design parameter values.

7. A printed circuit board designing method for supporting a determination of respective values of a plurality of specified design parameters, comprising a parameter reception step, a plurality of first parameter determination steps, a plurality of second parameter determination steps, and a printed circuit board layout step, wherein:
said parameter reception step receives at least one known design parameter value which is included in the respective values of the plurality of specified design parameters;
each first parameter determination step determines at least one unknown design parameter value using a rule and at least one design parameter value out of
(a) the design parameter values received by said parameter reception step,
(b) at least one design parameter value determined by other first parameter determination step, and
(c) a plurality of design parameter values determined by said plurality of second parameter determination steps,
wherein the rule includes a condition including the design parameter value used for determining the unknown design parameter value and a result relating to the unknown design parameter value;
each second parameter determination step determines at least one unknown design parameter value using at least one formula and at least one design parameter value out of
(a) the design parameter values received by said parameter reception step,
(b) a plurality of design parameter values determined by said plurality of first parameter determination steps, and
(c) at least one design parameter value determined by other second parameter determination step,
wherein the formula includes the unknown design parameter value and the design parameter value used for determining the unknown design parameter value; and
said layout step lays out a printed circuit board using the respective values of the plurality of specified design parameters, and
wherein at least a parameter determination step which operates first among said plurality of first parameter determination steps and said plurality of second parameter determination steps uses at least one of the design parameter values received by said parameter reception step in determining at least one unknown design parameter value.

8. The printed circuit board designing method of Claim 7, wherein the unknown design parameter values determined by said plurality of first parameter determination steps and the unknown design parameter values determined by said plurality of second parameter determination steps are design parameter values concerning at least one of a wire and a board.

9. The printed circuit board designing method of Claim 7, further comprising:
parameter determination re-execution instruction step for fixing, when a design parameter value which violates any of the rules and the formulas exists after said layout step lays out the printed circuit board, the design parameter value and having each first parameter determination step whose rule is violated by the design parameter value and each second parameter determination step whose formula is violated by the design parameter value re-execute a determination of the design parameter values,
wherein in the re-execution of the first parameter determination steps and the second parameter determination steps design parameter values other than the fixed design parameter value are treated as unknown design parameters.

10. The printed circuit board designing method of Claim 9, further comprising:
parameter determination order decision step for deciding, based on any of a plurality of predetermined standards, an execution order of said plurality of first parameter determination steps and said plurality of second parameter determination steps.

11. The printed circuit board designing method of Claim 10,
wherein the plurality of predetermined standards include a standard rule based on at least one of the plurality of known design parameter values.

12. The printed circuit board designing method of Claim 10,
wherein the plurality of predetermined standards include a standard that gives priority in the execution order to a parameter determination step, out of said plurality of first parameter determination steps and said plurality of second parameter determination steps, which determines a small number of unknown design parameter values.

13. A computer-readable recording medium which records a program for instructing a computer to execute a printed circuit board designing method for supporting a determination of respective values of a plurality of specified design parameters, the method comprising a parameter reception step, a plurality of first parameter determination steps, a plurality of second parameter determination steps, and a printed circuit board layout step, wherein:
said parameter reception step receives at least one known design parameter value which is included in the respective values of the plurality of specified design parameters;
each first parameter determination step determines at least one unknown design parameter value using a rule and at least one design parameter value out of
(a) the design parameter values received by said parameter reception step,
(b) at least one design parameter value determined by other first parameter determination step, and
(c) a plurality of design parameter values determined by said plurality of second parameter determination steps,
wherein the rule includes a condition including the design parameter value used for determining the unknown design parameter value and a result relating to the unknown design parameter value;
each second parameter determination step determines at least one unknown design parameter value using at least one formula and at least one design parameter value out of
(a) the design parameter values received by said parameter reception step,
(b) a plurality of design parameter values determined by said plurality of first parameter determination steps, and
(c) at least one design parameter value determined by other second parameter determination step,
wherein the formula includes the unknown design parameter value and the design parameter value used for determining the unknown design parameter value; and
said layout step lays out a printed circuit board using the respective values of the plurality of specified design parameters, and
wherein at least a parameter determination step which operates first among said plurality of first parameter determination steps and said plurality of second parameter determination steps uses at least one of the design parameter values received by said parameter reception step in determining at least one unknown design parameter value.

14. The recording medium of Claim 13, wherein the unknown design parameter values determined by said plurality of first parameter determination steps and the unknown design parameter values determined by said plurality of second parameter determination steps are design parameter values concerning at least one of a wire and a board.

15. The recording medium of Claim 13, wherein the method further comprises:
parameter determination re-execution instruction step for fixing, when a design parameter value which violates any of the rules and the formulas exists after said layout step lays out the printed circuit board, the design parameter value and having each first parameter determination step whose rule is violated by the design parameter value and each second parameter determination step whose formula is violated by the design parameter value re-execute a determination of the design parameter values,
wherein in the re-execution of the first parameter determination steps and the second parameter determination steps design parameter values other than the fixed design parameter value are treated as unknown design parameters.

16. The recording medium of Claim 15, wherein the method further comprises:
parameter determination order decision step for deciding, based on any of a plurality of predetermined standards, an execution order of said plurality of first parameter determination steps and said plurality of second parameter determination steps.

17. The recording medium of Claim 16,
wherein the plurality of predetermined standards include a standard rule based on at least one of the plurality of known parameter values.

18. The recording medium of Claim 16,
wherein the plurality of predetermined standards include a standard that gives priority in the execution order to a parameter determination step, out of said plurality of first parameter determination steps and said plurality of second parameter determination steps, which determines a small number of unknown design parameter values.
